Europäisches Patentamt

(19) European Patent Office

Office européen des brevets

(11) Veröffentlichungsnummer : **0 028 799**
**B1**

(12) **EUROPÄISCHE PATENTSCHRIFT**

(45) Veröffentlichungstag der Patentschrift :
11.05.83

(21) Anmeldenummer : 80106777.8

(22) Anmeldetag : 04.11.80

(51) Int. Cl.³ : **H 01 L 29/747,** H 01 L 29/74,
H 01 L 29/52, H 01 L 29/08

(54) **Triac mit einem Mehrschichten-Halbleiterkörper und Verfahren zu seinem Betrieb.**

(30) Priorität : 09.11.79 DE 2945380

(43) Veröffentlichungstag der Anmeldung :
20.05.81 Patentblatt 81/20

(45) Bekanntmachung des Hinweises auf die Patenterteilung : 11.05.83 Patentblatt 83/19

(84) Benannte Vertragsstaaten :
CH FR GB IT LI SE

(56) Entgegenhaltungen :
DE A 2 625 917
FR A 1 362 724
US A 4 199 774
ELECTRONIC DESIGN, Band 4, 15. Februar 1978,
Rochelle, US D. BARNES : « MOS-controlled triac
combines low input power, high output power »,
Seiten 32, 34
ELECTRONIQUE ET APPLICATIONS INDUS-
TRIELLES, Nr. 281, März 1980, Paris, FR,
Y. SOUSSI : « La commande optique des courants alternatifs de puissance », Seiten 30, 31

(73) Patentinhaber : **SIEMENS AKTIENGESELLSCHAFT**
**Berlin und München Wittelsbacherplatz 2**
**D-8000 München 2 (DE)**

(72) Erfinder : **Patalong, Hubert, Dr.**
**Kurt-Floericke-Strasse 18**
**D-8000 München 60 (DE)**

## Triac mit einem Mehrschichten-Halbleiterkörper und Verfahren zu seinem Betrieb

Die Erfindung bezieht sich auf ein Triac mit einem Mehrschichten-Halbleiterkörper nach dem Oberbegriff des Anspruchs 1 und auf Verfahren zu seinem Betrieb.

Triacs dieser Art, die beispielsweise aus dem Buch « Thyristor Physics » von Adolph Blicher, Springer Verlag, Berlin, 1976, Seite 133, Figur 11.2, bekannt sind, weisen den Nachteil auf, daß sie nur bei niedrigem Kommutierungs-dU/dt-Werten verwendet werden können. Ändert sich die an den Elektroden anliegende Spannung in der Nähe ihres Nulldurchgangs sehr rasch, so sind keine kontrollierten Schaltvorgänge mehr möglich.

Der Erfindung liegt die Aufgabe zugrunde, ein Triac der eingangs genannten Art anzugeben, das auch bei hohen Kommutierungs-dU/dt-Werten einwandfreie Schaltvorgänge gewährleistet. Diese Aufgabe wird erfindungsgemäß durch die im Anspruch 1 gekennzeichneten Merkmale gelöst. Der mit der Erfindung erzielbare Vorteil liegt insbesondere darin, daß eine weitgehende Entkopplung der beiden zu einem Triac zusammengefaßten Thyristoren erzielt wird, so daß die Schaltvorgänge von der Änderungsgeschwindigkeit der an den Elektroden anliegenden Spannung in der Nähe ihres Nulldurchgangs weitgehend unbeeinflußt bleiben. Außerdem unterscheiden sich die Durchlaßeigenschaften wegen der mit Hilfe der Emitter-Kurzschlußpfade erzielten guten Entkopplung vorteilhaft von herkömmlichen Triacs, bei denen zum Zwecke der besseren gegenseitigen Entkopplung der beiden Thyristoren zusätzliche Rekombinationszentren eingebaut werden.

Steuerbare Emitter-Kurzschlußpfade sind in Verbindung mit Thyristoren aus der US-A-3 243 669 bekannt. Ein Hinweis auf eine Beeinflussung der Entkopplungseigenschaften zweier zu einer Triac-Mehrschichtenstruktur zusammengefaßter Thyristoren ist dieser Veröffentlichung jedoch nicht zu entnehmen.

Die Unteransprüche sind auf bevorzugte Weiterbildungen und Ausgestaltungen der Erfindung sowie auf Verfahren zum Betrieb eines erfindungsgemäß ausgebildeten Triacs gerichtet.

Die Erfindung wird nachfolgend anhand der Zeichnung näher erläutert. Dabei zeigt :

Figur 1 ein bevorzugtes Ausführungsbeispiel und

Figur 2 Zeit-Diagramme zur Erläuterung der Anordnung nach Fig. 1.

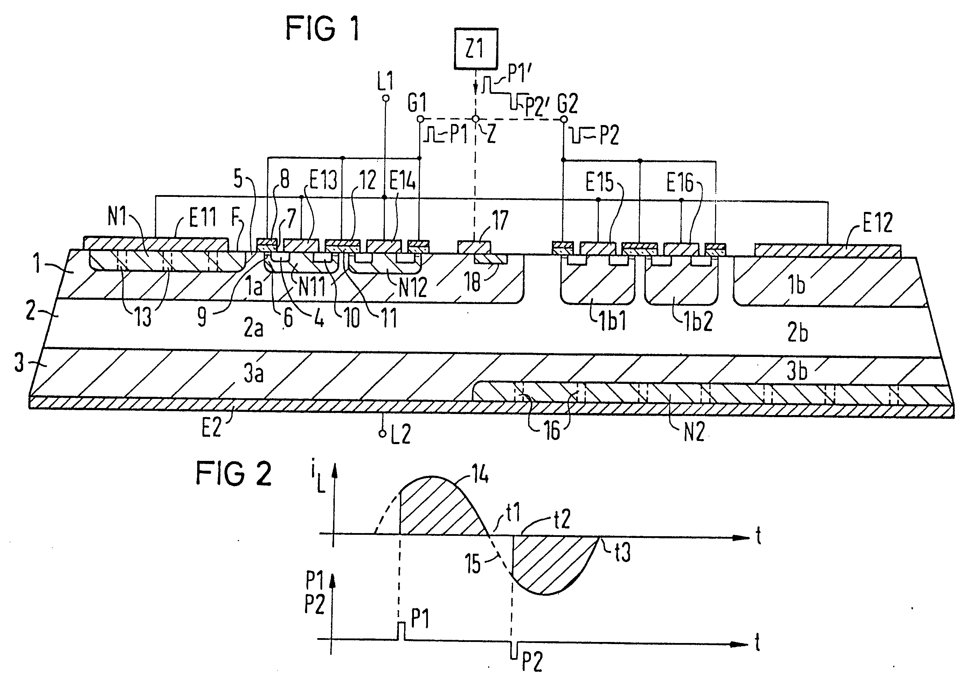

In Figur 1 ist ein Triac dargestellt, dessen Körper aus Halbleiterschichten abwechselnder Leitfähigkeitstypen gebildet ist, die beispielsweise aus dotiertem Silizium bestehen. Eine P-leitende Schicht 1 umfaßt sowohl die P-Basisschicht 1a eines in der linken Hälfte von Fig. 1 dargestellten, ersten Thyristors als auch die P-Emitterschicht 1b eines zweiten, in der rechten Hälfte von Fig. 1 dargestellten Thyristors. Eine N-leitende Schicht 2 bildet die N-Basisschichten 2a und 2b beider Thyristoren, während die Schicht 3 die P-Emitterschicht 3a des linken und die P-Basisschicht 3b des rechten Thyristors umfaßt. In der Schicht 1a ist die N-Emitterschicht N1 des ersten Thyristors eingefügt, während in die Schicht 3b die N-Emitterschicht N2 des zweiten Thyristors eingefügt ist. Die Schichten N1 und 1b sind mit Teilen E11 und E12 einer ersten Elektrode verbunden, die an einen gemeinsamen Anschluß L1 geführt sind. Andererseits sind die Schichten 3a und 3b mit einer zweiten Elektrode E2 verbunden, die einen Anschluß L2 aufweist.

Der in Fig. 1 rechts liegende Teil der N-Emitterschicht N1 ist in zwei streifenförmige Teilschichten N11 und N12 aufgeteilt, die jeweils mit weiteren Teilen E13 und E14 der ersten Elektrode verbunden sind. In analoger Weise ist der links liegende Teil der P-Emitterschicht 1b in zwei streifenförmige Teilschichten 1b1 und 1b2 aufgeteilt, die jeweils mit zwei Teilen E15 und E16 der ersten Elektrode versehen sind. Die streifenförmigen Teilschichten N11, N12 und 1b1, 1b2 verlaufen parallel zueinander und im wesentlichen senkrecht zur Bildebene von Fig. 1, ebenso die Teile E13, E14, E15 und E16 der ersten Elektrode. Letztere sind mit den Teilen E11 und E12 an einen Anschluß L1 geführt.

In die Teilschicht N11 ist ein erstes Halbleitergebiet 4 eingefügt, das P-leitend ist und sich bis zur Grenzfläche F des Halbleiterkörpers erstreckt. In dieser wird es von dem Teil E13 kontaktiert. 5 bezeichnet ein zweites P-leitendes Halbleitergebiet, das aus einer Zone der P-Basisschicht 1a besteht, die bis an die Grenzfläche F reicht und die Schichten N1 und N11 voneinander trennt. Zwischen diesen Halbleitergebieten 4 und 5 befindet sich eine N-leitende Zwischenschicht 6, die aus einem Teil von N11 besteht. Diese Zwischenschicht 6 ist durch eine an der Grenzfläche F angeordnete, dünne, elektrisch isolierende Schicht, z. B. aus SiO$_2$, abgedeckt, welche mit einem Gate 8 versehen ist. Das Gate 8 ist mit einem Anschluß G1 verbunden. Die Teile 4 bis 8 bilden eine über G1 steuerbare MIS-Struktur. Gehört diese dem Verarmungstyp an, so befindet sich ohne Einwirkung einer Spannung auf das Gate 8 ein P-leitender Inversionskanal 9 an der Grenzfläche F zwischen den Gebieten 4 und 5, der diese leitend miteinander verbindet. Legt man eine positive Steuerspannung an den Anschluß G1, so wird dieser Inversionskanal beseitigt. Ist die MIS-Struktur vom Anreicherungstyp, so besteht bei spannungslosem Gate 8 kein Inversionskanal 9. Dieser wird erst durch das Anlegen einer negativen Steuerspannung an G1 durch Inversion der Zwischenschicht 6 unterhalb des Gate 8 aufgebaut.

Der Inversionskanal 9 stellt also einen steuerbaren Emitter-Kurzschlußpfad dar, der die Basisschicht 1a mit dem Gebiet 4 und damit mit dem Teil E13 der ersten Elektrode in Abhängigkeit von einer dem Anschluß G1 zugeführten Steuerspannung niederohmig verbindet oder nicht.

Durch die Anordnung eines P-leitenden Gebietes 10, einer elektrisch isolierenden Schicht 11, z. B. aus SiO$_2$, und einem auf dieser angeordneten Gate 12, das ebenfalls mit G1 verbunden ist, ergibt sich eine weitere MIS-Struktur, die ebenfalls einen Emitter-Kurzschlußpfad enthält, der zwischen der Schicht 1a und dem Teil E13 der ersten Elektrode verläuft. Während der erste Kurzschlußpfad, der aus dem Inversionskanal 9 besteht, am linken Rand der Teilschicht N11 angeordnet ist, befindet sich der zweite Kurzschlußpfad am rechten Rande von N11. In gleicher Weise sind zwei Emitter-Kurzschlußpfade an den Seiten der Teilschicht N12 vorgesehen, die 1a wahlweise mit dem Teil E14 verbinden. Weitere Emitter-Kurzschlußpfade verbinden die Schicht 2b mit dem Teil E15 und die Teilschicht 2b mit dem Teil E16 der ersten Elektrode. Dabei erfolgt die Ansteuerung der im einzelnen nicht bezeichneten Gates der seitlich von 1b1 und 1b2 liegenden MIS-Strukturen über einen gemeinsamen Anschluß G2. Da die Leitfähigkeitstypen der Teile der letztgenannten MIS-Strukturen zu denen der MIS-Struktur 4 bis 7 entgegengesetzt sind, sind über den Anschluß G2 auch jeweils Steuerspannungen zuzuführen, die zu denen an G1 anliegenden Steuerspannungen die entgegengesetzte Polarität aufweisen.

Bei MIS-Strukturen des Verarmungstyps sind die Emitter-Kurzschlußpfade bei spannungslosen Anschlüssen G1 und G2 jeweils wirksam. Legt man eine Wechselspannung an die Anschlüsse L1 und L2, die zunächst das Potential von L1 gegenüber dem Potential von L2 verringert, so befindet sich der erste Transistor im blockierten Zustand, in dem er trotz der in Durchlaßrichtung an L1 und L2 anliegenden Spannung keinen Laststrom zwischen L1 und L2 zuläßt. Die thermisch genertierten Defektelektronen werden aus der Basisschicht 1a über die wirksamen Kurzschlußpfade zur ersten Elektrode abgeleitet, so daß aus den N-Emitter-Teilschichten N11 und N12 keine Ladungsträger in die Basisschicht 1a injiziert werden. Damit auch aus dem mit N1 bezeichneten Teil der Emitterschicht keine Ladungsträger in die Basisschicht 1a injiziert werden, sind in N1 sogenannte feste Emitter-Kurzschlüsse 13 vorgesehen.

Diese bestehen aus Teilen der Basisschicht 1a, die die Schicht N1 durchdringen und bis zur Grenzfläche F reichen, in der sie von dem Teil E11 kontaktiert werden. Die Wirkung dieser festen Kurzschlüsse ist dabei dieselbe wie die von Emitter-Kurzschlußpfaden, die ständig wirksam geschaltet sind. Daher wird durch die Anordnung der festen Kurzschlüsse 13 erreicht, daß auch von N1 keine Ladungsträger in die Basisschicht 1a injiziert werden.

Wird nun dem Anschluß G1 ein positiver Spannungsimpuls P1 zugeführt, so werden die steuerbaren Kurzschlußpfade seitlich von N11 und N12 unterbrochen. Die Teilschichten N11 und N12 beginnen Ladungsträger in die Basisschicht 1a zu injizieren und der erste Thyristor zündet. Diese Zündung, die zunächst nur im Bereich der Teilschichten N11 und N12 beginnt, breitet sich auch auf den mit N1 bezeichneten Teil der N-Emitterschicht aus. Wie aus Fig. 2 ersichtlich ist, beginnt ein Laststrom $i_L$ nach dem Auftreten von P1 zu fließen, und zwar ergibt sich eine durch die Kurve 14 gegebene Abhängigkeit des Laststroms $i_L$ von der Zeit t.

Der rechte Thyristor ist bis zum Zeitpunkt t1 über die Anschlüsse L1 und L2 in Sperrichtung gepolt, so daß er nicht gezündet ist und über ihn keine Laststromanteile fließen.

Da seine randseitig zu den Teilschichten 1b1 und 1b2 angeordneten Emitter-Kurzschlußpfade wegen des spannungslosen Anschlusses G2 wirksam geschaltet sind, können Ladungsträger, die aus dem Bereich des gezündetem linken Thyristors in den Grenzbereich zwischen beiden Thyristoren gelangt sind, über die Teile E15 und E16 abgeleitet werden. Dies gilt auch für den Zeitraum nach t1, in dem der linke Thyristor wegen des Nulldurchgangs der an L1 und L2 anliegenden Spannung gesperrt wird und der rechte Thyristor in Durchlaßrichtung gepölt ist. Erst beim Auftreten eines negativen Spannungsimpulses P2 an G2 zum Zeitpunkt t2 werden die seitlich von 1b1 und 1b2 liegenden Emitter-Kurzschlußpfade unterbrochen, so daß Defektelektronen aus der Basisschicht 2b zu den PN-Übergängen zwischen 1b1 und 1b2 und 2b gelangen und die Schichten 1b1 und 1b2 Ladungsträger in die Basisschicht 2b injizieren. Damit beginnt erst zum Zeitpunkt t2 die Umschaltung des rechten Thyristors aus dem blockierten in den stromführenden Zustand, wie auch aus der Stromkurve 15 in Figur 2 hervorgeht. Bis zum nächst folgenden Nulldurchgang der an L1 und L2 anliegenden Spannung zum Zeitpunkt t3 führt der rechte Thyristor in Fig. 1 den Laststrom $i_L$.

Ohne die beschriebene Wirkung der seitlich von 1b1 und 1b2 angeordneten Emitter-Kurzschlußpfade würde es zu einer unerwünschten Zündung des rechten Thyristors vor dem Zeitpunkt t2 kommen, da vom linken Thyristor stammende, aus der Schicht 2a in das Gebiet der Schicht 2b gelangte Ladungsträger eine vorschnelle Zündung veranlassen würden. In diesem Fall würde der Laststrom $i_L$ im Zeitraum zwischen t1 und t2 nicht, wie gewünscht, auf Null absinken, sondern dem Kurventeil 15 entsprechen, der in Fig. 2 gestrichelt eingezeichnet ist. Damit wäre aber ein normaler Schaltbetrieb eines Triacs nicht möglich.

Zur besseren Stabilität des in Fig. 1 rechts eingezeichneten Thyristors sind feste Kurzschlüsse 16 der bereits beschriebenen Art in der N-Emitterschicht N2 vorgesehen. Diese verhindern ein unerwünschtes Zünden des rechten Thyristors in dem Zeitintervall von t1 bis t2 im Bereich der Schicht N2.

Nach einer Weiterbildung der Erfindung können die Anschlüsse G1 und G2 miteinander verbunden werden. Hierbei werden Doppelimpulse P1, P2 entsprechend Figur 2 beiden Anschlüssen gemeinsam zugeführt. An der Wirkungsweise des Triac ändert sich hierdurch nichts.

Zur Unterstützung und Beschleunigung der Zündvorgänge beider Thyristoren kann nach einer Ausgestaltung der Erfindung eine Zündelektrode 17 auf der Basisschicht des einen der beiden Thyristoren vorgesehen sein. Diese kontaktiert gemäß Fig. 1 sowohl die P-Basis 1a als auch ein N-leitendes Steuergebiet 18, das innerhalb der Schicht 1a liegt. Beim Auftreten eines positiven Zündimpulses P1', der über einen Anschluß Z eines Zündstromkreises Z1 an die Elektrode 17 gelangt, wird ein Zündimpuls in die Basis 1a eingespeist. Beim Auftreten eines negativen Zündimpulses P2' gelangen Ladungsträger in an sich bekannter Weise aus dem Steuergebiet 18 in die Basisschicht 2b und beschleunigen den Zündvorgang im rechten Thyristor. Verbindet man die Anschlüsse G1 und G2 mit Z, so werden die dort abgreifbaren positiven und negativen Zündspannungsimpulse als Steuerimpulse P1 und P2 benutzt.

## Ansprüche

1. Triac mit einem zwischen zwei Elektroden (E11-E16 ; E2) angeordneten Mehrschichten-Halbleiterkörper, bei dem eine erste Schicht (1) die P-Basisschicht (1a) eines ersten und die P-Emitterschicht (1b) eines zweiten Thyristors bildet, eine zweite Schicht (2), die N-Basisschichten (2a, 2b) beider Thyristoren darstellt und eine dritte Schicht (3) die P-Emitterschicht (3a) des ersten und die P-Basisschicht (3b) des zweiten Thyristors bildet und bei dem in die erste Schicht die N-Emitterschicht (N1, N11, N12) des ersten und in die dritte Schicht (3) die N-Emitterschicht (N2) des zweiten Thyristors jeweils als mit den Elektroden verbundene Schichten eingefügt sind, dadurch gekennzeichnet, daß an den einander zugewandten Rändern der N-Emitterschicht (N11, N12) des ersten und der P-Emitterschicht (1b1, 1b2) des zweiten Thyristors jeweils mindestens ein als MIS-Struktur ausgebildeter gategesteuerter Emitter-Kurzschlußpfad (4, 9, 5) vom Emitter zur anliegenden Basis vorgesehen sind.

2. Triac nach Anspruch 1, dadurch gekennzeichnet, daß die Emitter-Kurzschlußpfade (4, 9, 5) jeweils aus einem ersten Halbleitergebiet (4) eines ersten Leitfähigkeitstyps, das mit der die zugehörige Emitterschicht kontaktierenden Elektrode (E13) verbunden ist, aus einem zweiten Halbleitergebiet (5) des ersten Leitfähigkeitstyps, das mit der an die zugehörige Emitterschicht angrenzenden Basisschicht (1a) verbunden ist, und aus einer zwischen diesen Gebieten (4, 5) liegenden Zwischenschicht (6) eines zweiten Leitfähigkeitstyps, die von einem gegenüber dem Halbleiterkörper elektrisch isolierten Gate (8) überdeckt ist, bestehen.

3. Triac nach Anspruch 2, dadurch gekennzeichnet, daß jeweils das erste Halbleitergebiet (4) eines Emitter-Kurzschlußpfades in eine Randzone der zugehörigen Emitterschicht (N11) derart eingefügt ist, daß es sich bis zu der Grenzfläche (F) des Halbleiterkörpers erstreckt, die die Emitterschicht kontaktierende Elektrode (E13) aufweist, und in dieser mit ihr leitend verbunden ist, daß das zweite Halbleitergebiet (5) aus einer Zone der angrenzenden Basisschicht (1a) besteht, die sich bis in die Grenzfläche (F) erstreckt, und daß die Zwischenschicht (6) aus einem Teil der Emitterschicht (N11) besteht.

4. Triac nach einem der vorhergehenden Ansprüche, dadurch gekennzeichnet, daß die N-Emitterschicht des ersten und die P-Emitterschicht des zweiten Thyristors an den einander zugewandten Seiten in mehrere streifenförmige Teilschichten (N11, N12, 1b1, 1b2) aufgeteilt sind, die jeweils mit Teilen (E13, E14, E15, E16) der die Emitterschicht kontaktierenden Elektrode versehen sind und daß eine Mehrzahl von steuerbaren Emitter-Kurzschlußpfaden randseitig zu den streifenförmigen Teilschichten (N11, N12, 1b1, 1b2) angeordnet sind.

5. Triac nach einem der vorhergehenden Ansprüche, dadurch gekennzeichnet, daß die gesteuerten Emitter-Kurzschlußpfade beider Thyristoren einen gemeinsamen Steueranschluß aufweisen.

6. Triac nach einem der vorhergehenden Ansprüche, dadurch gekennzeichnet, daß die P-Basisschicht (1a) des einen Thyristors mit einer Zündelektrode (17) versehen ist, die einen Anschluß für einen Zündstromkreis (Z1) aufweist, und ein in diese Basisschicht (1a) eingefügtes, zu dieser entgegengesetzt dotiertes Steuergebiet (18) kontaktiert.

7. Triac nach den Ansprüchen 5 und 6, dadurch gekennzeichnet, daß der gemeinsame Steueranschluß mit dem Anschluß (Z) des Zündstromkreises (Z1) verbunden ist.

8. Triac nach einem der vorhergehenden Ansprüche, dadurch gekennzeichnet, daß die N-Emitterschichten (N1, N2) beider Thyristoren jeweils von wenigstens einer Zone der angrenzenden Basisschichten (1a, 3b) durchdrungen sind, daß sich diese Zone jeweils bis zu der der jeweiligen N-Emitterschicht benachbarten Grenzfläche des Halbleiterkörpers erstreckt und in dieser mit der die jeweilige N-Emitterschicht kontaktierenden Elektrode (E11, E2) verbunden ist.

9. Verfahren zum Betrieb eines Triac nach Anspruch 1, dadurch gekennzeichnet, daß einem Steueranschluß (G1) der Emitter-Kurzschlußpfade des ersten Thyristors Spannungsimpulse (P1) einer ersten Polarität und einem Steueranschluß (G2) der Emitter-Kurzschlußpfade des zweiten Thyristors Spannungsimpulse (P2) einer zweiten Polarität zugeführt werden.

10. Verfahren zum Betrieb eines Triac nach Anspruch 5, dadurch gekennzeichnet, daß dem gemeinsamen Steueranschluß der Emitter-Kurzschlußpfade beider Thyristoren Spannungsimpulse unterschiedlicher Polarität zugeführt werden.

## Claims

1. A triac having a multi-layer semiconductor body arranged between two electrodes (E11-E16 ; E2), in which a first layer (1) forms the P-base layer (1a) of a first thyristor and the P-emitter layer (1b) of a second thyristor, a second layer (2) forms the N-base layers (2a, 2b) of the two thyristors, and a third layer (3) forms the P-emitter layer (3a) of the first thyristor and the P-base layer (3b) of the second thyristor, and in which the N-emitter layer (N1, N11, N12) of the first thyristor is introduced into the first layer and the N-emitter layer (N2) of the second thyristor is introduced into the third layer (3), as layers which are connected to the electrodes, characterised in that at the facing edges, of the N-emitter layer (N11, N12) of the first thyristor, and of the P-emitter layer (1b1, 1b2) of the second thyristor, there is in each case arranged at least one gate-controlled emitter short-circuit path (4, 9, 5) from the emitter to the adjacent base, which is formed as a MIS-structure.

2. A triac according to Claim 1, characterised in that the emitter short-circuit paths (4, 9, 5) in each case consist of a first semiconductor zone (4) of a first conductivity type which is connected to the electrode (E13) contacting the relevant emitter layer, a second semiconductor zone (5) of the first conductivity type which is connected to the base layer (1a) adjoining the relevant emitter layer, and an intermediate layer (6) of a second conductivity type which is arranged between these zones (4, 5) and which is covered by a gate (8) which is electrically insulated from the semiconductor body.

3. A triac according to Claim 2, characterised in that in each case, the first semiconductor region (4) of an emitter short-circuit path is introduced into a boundary zone of the relevant emitter layer (N11) in such a way that it extends to the boundary surface (F) of the semiconductor body which has the electrode (E13) which contacts the emitter layer, and is conductively connected to this electrode so as to be conductive in the boundary surface ; that the second semiconductor region (5) consists of a zone of the adjacent base layer (1a) which extends to the boundary surface (F) ; and that the intermediate layer (6) consists of a portion of the emitter layer (N11).

4. A triac according to one of the preceding Claims, characterised in that the N-emitter layer of the first thyristor and the P-emitter layer of the second thyristor are divided into a plurality of stripshaped partial layers (N11, N12, 1b1, 1b2) on the sides which face one another, which partial layers are respectively provided with parts (E13, E14, E15, E16) of the electrode which contacts the emitter layer ; and that a plurality of controllable emitter short-circuit paths are arranged at the edges of the strip-shaped partial layers (N11, N12, 1b1, 1b2).

5. A triac according to one of the preceding Claims, characterised in that the controlled emitter short-circuit paths of both thyristors have a common control terminal.

6. A triac according to one of the preceding Claims, characterised in that the P-base layer (1a) of the one thyristor is provided with an ignition electrode (17) having a connection for an ignition circuit (Z1) and contacts a control region (18) which is introduced into the base layer (1a) and is oppositely doped thereto.

7. A triac according to Claims 5 and 6, characterised in that the common control terminal is connected to the terminal (Z) of the ignition circuit (Z1).

8. A triac according to one of the preceding Claims, characterised in that the N-emitter layers (N1, N2) of both thyristors are each penetrated by at least one zone of the adjoining base layers (1a, 3b) ; in each case, this zone extends to the boundary surface of the semiconductor body which is adjacent to the respective N-emitter layer, and is connected to the electrode (E11, E2) which contacts the respective N-emitter layer.

9. A method of operating a triac according to Claim 1, characterised in that a control terminal (G1) of the emitter short-circuit paths of the first thyristor is fed with voltage pulses (P1) of a first polarity and a control terminal (G2) of the emitter short-circuit paths of the second thyristor is fed with voltage pulses (P2) of a second polarity.

10. A method of operating a triac according to Claim 5, characterised in that the common control terminal of the emitter short-circuit paths of both thyristors is supplied with voltage pulses of different polarity.

## Revendications

1. Triac avec un corps semiconducteur multi-couches disposé entre deux électrodes (E11-E1 ; E2), dans lequel une première couche (1) forme la couche de base (1a) du type de conductivité P d'un premier et la couche d'émetteur (1b) du type de conductivité P d'un second thyristor, une seconde couche (2) représente les couches de base (2a, 2b) du type de conductivité N des deux transistors et une troisième couche (3) forme la couche d'émetteur (3a) du type de conductivité P du premier et la couche de base (3b) du type de conductivité P du second transistor, et dans lequel on insère dans la première couche la couche d'émetteur (N1, N11, N12) du type de conductivité N du premier et dans la troisième couche (3) la couche d'émetteur (N2) du type de conductivité N du second thyristor, respectivement sous la forme de couches reliées aux électrodes, caractérisé par le fait qu'il est prévu, sur les bords voisins entre eux de la couche d'émetteur (N11, N12) du type de conductivité N du premier et de la couche d'émetteur (1b1, 1b2) du type de conductivité P du second transistor, respectivement au moins une piste de court-circuit d'émetteur (4, 9, 5), de l'émetteur à la base voisine, et réalisée sous la forme d'une structure MIS commandée par une porte.

2. Triac selon la revendication 1, caractérisé par le fait que les pistes de court-circuits d'émetteurs (4, 9, 5) sont chacune constituées par une première zone semiconductrice (4) d'un premier type de conductivité et reliées à l'électrode (E13) qui contacte la couche d'émetteur associée, par une seconde zone semiconductrice (5) du premier type de conductivité, et reliée à la couche de base (1a) qui jouxte la couche d'émetteur associée et par une couche intermédiaire (6), située entre ces deux zones (4, 5), d'un second type de conductivité et qui est recouverte par une porte (8) électriquement isolée par rapport au corps semiconducteur.

3. Triac selon la revendication 2, caractérisé par le fait que, respectivement, la première zone semiconductrice (4) d'une piste de court-circuit d'émetteur est insérée dans une zone marginale de la couche d'émetteur associée (N11) de telle manière qu'elle s'étende jusqu'à la surface limite (F) du corps semiconducteur qui comporte l'électrode (E13) qui contacte la couche d'émetteur et y est reliée électriquement avec celle-ci, que la seconde zone semiconductrice (5) est constituée par une zone de la couche de base (1a), qui s'étend jusqu'à la surface limite (F), et que la couche intermédiaire (6) est constituée par une partie de la couche d'émetteur (N11).

4. Triac selon l'une des revendications antérieures, caractérisé par le fait que la couche d'émetteur du type de conductivité N du premier et la couche d'émetteur du type de conductivité P du second transistor sont subdivisées, sur leurs côtés qui sont voisins, en plusieurs couches partielles (N11, N12, 1b1, 1b2) en forme de bandes, lesdites couches partielles étant respectivement pourvues d'électrodes qui contactent des parties (E13, E14, E15, E16) de la couche d'émetteur, et que plusieurs pistes de court-circuits d'émetteurs, susceptibles d'être commandées, sont disposées, en position marginale, par rapport aux couches partielles (N11, N12, 1b1, 1b2) en forme de bandes.

5. Triac selon l'une des revendications antérieures, caractérisé par le fait que les pistes de court-circuits d'émetteurs des deux transistors, qui sont commandées, comportent une borne de commande commune.

6. Triac selon l'une des revendications antérieures, caractérisé par le fait que la couche de base (1a) du type de conductivité P de l'un des thyristors est pourvue d'une électrode de déclenchement (17) qui comporte une borne pour un circuit de courant de déclenchement (Z1) et contacte une zone de commande (18) insérée dans la couche de base (1a) et dopée en sens opposé à cette dernière.

7. Triac selon les revendications 5 et 6, caractérisé par le fait que la bande de commande commune est reliée à la borne (Z) du circuit de courant de déclenchement (Z1).

8. Triac selon l'une des revendications précédentes, caractérisé par le fait que les couches d'émetteurs (N1, N2) du type de conductivité N des deux transistors sont respectivement traversées par au moins une zone des couches de base avoisinnantes (1a, 3b), que chacune de ces zones s'étend jusqu'à la surface limite du corps semiconducteur qui est voisine de la couche d'émetteur correspondante, du type de conductivité N, et est reliée dans cette surface limite avec l'électrode (E11, E2) qui contacte la couche d'émetteur correspondante du type de conductivité N.

9. Procédé pour la mise en œuvre d'un triac selon la revendication 1, caractérisé par le fait qu'à une borne de commande (G1) des pistes de court-circuits d'émetteurs du premier transistor sont appliquées des impulsions de tension (P1) d'une première polarité et qu'à une borne de commande (G2) des pistes de court-circuits d'émetteurs du second transistor sont appliquées des impulsions de tension (P2) d'une seconde polarité.

10. Procédé pour la mise en œuvre d'un triac selon la revendication 5, caractérisé par le fait qu'à la borne de commande commune, des pistes de court-circuits d'émetteurs des deux transistors sont appliquées des impulsions de tension de polarité différente.

FIG 1

FIG 2